# EUROPÄISCHE PATENTANMELDUNG

(11) **EP 4 471 650 A1**
(43) Veröffentlichungstag der Anmeldung: **04.12.2024**
(21) Anmeldenummer: 23176385.5
(22) Anmeldetag: 31.05.2023
(51) Int. Cl.: G06F 30/20, G05B 17/02

(54) **VERFAHREN ZUM ERSTELLEN EINES RESTMODELLS FÜR EIN SIMULATIONSSYSTEM**

(71) Anmelder: dSPACE GmbH, 33102 Paderborn (DE)
(72) Erfinder: Sielhorst, Tobias, 33102 Paderborn (DE)

(57) **Zusammenfassung**

Erfindungsgemäß wird ein Verfahren zum Erstellen eines Restmodells (3) für ein eine Mehrzahl von Teilmodellen (11, 12, 13, 21, 22) aufweisendes Simulationssystem (1), mit folgenden Verfahrensschritten bereitgestellt:
Auswählen mindestens eines Teilmodells (11, 12, 13, 21, 22) als Zielmodell (21, 22), das nicht im Restmodell (3) enthalten sein soll,
Erfassen von Ports des Simulationssystems (1), die mit Ports des Zielmodells (21, 22) verbunden werden müssen,
Erstellen von den erfassten Ports entsprechender Ports mit identischen Eigenschaften in dem Restmodell (3),
Erfassen von Feldbussen des Simulationssystems (1), die mit dem Zielmodell (21, 22) verbunden werden müssen, und
Erstellen von für die erfassten Feldbussen geeigneten Feldbus-Controllern in dem Restmodell (3).

## Beschreibung

Die Erfindung betrifft ein Verfahren zum Erstellen eines Restmodells für ein eine Mehrzahl von Teilmodellen aufweisendes Simulationssystem.

Ein virtuelles Steuergerät, eine sogenannte V-ECU, ist eine Software, die in einem Simulationsszenario ein echtes Steuergerät oder einen Teil eines echten Steuergeräts simuliert. Verschiedene V-ECU-Versionen decken einen großen Variantenbereich ab - von sehr einfachen Versionen bis hin zu einer Komplettversion, die alle Komponenten eines realen Steuergeräts enthält: Die einfachste Form einer V-ECU hat für jede Funktion nur eine Komponente. In einer vereinfachten Modellierung beinhaltet eine V-ECU beispielsweise nur eine einzige Applikationssoftwarekomponente und die unterschiedlichen darunterliegenden Schichten des Betriebssystems und der Treiber werden abstrahiert. In einer komplexeren Version enthält die V-ECU mehrere verknüpfte Software-Komponenten, zum Beispiel die komplette Funktionalität eines Steuergeräts. Im Bereich Automotive gehört z.B. auch die AUTOSAR Runtime Environment (RTE) und das Betriebssystem für realistisches Task Scheduling dazu. Bei Bedarf können ausgewählte Software-Komponenten hinzugefügt werden, um die Buskommunikation oder den NVRAM zu simulieren. Eine V-ECU wird noch realistischer, wenn der echte Basis-Software-Code hinzugefügt wird, der auch im Seriencode verwendet wird. Eine V-ECU enthält somit Komponenten von Applikations- und Basis-Software und bietet daher Funktionalitäten, die mit denen echter Steuergeräte vergleichbar sind. Eingesetzt wird sie z.B. für die Validierung während einer Computer-basierten Simulation.

Da beim Einsatz einer V-ECU nicht mit realer Steuergeräte-Hardware gearbeitet wird, kann die Simulation schneller als in Echtzeit erfolgen, so dass die Analyse des simulierten Steuergeräts sehr zeitsparend und komfortabel erfolgen kann. Durch Software-in-the-Loop-Test (SIL-Tests) in Computer-basierten Simulationen können Software-Funktionen, V-ECUs oder komplette V-ECU-Netzwerke simuliert und getestet werden.

Software-Entwicklungsprozess für klassische Automobilanwendungen, wie Antriebsstrang- oder Bremssystemen, bis hin zu E-Drive-Anwendungen und Funktionen für das autonome Fahren können mittels SIL-Tests durch virtuelles Testen und Validieren deutlich beschleunigt werden. So kann ein DUT (device under test) komfortabel auf einem Computer simuliert werden, es kann mit physikalisch basierten Modellen verbunden werden und Testskripte können später auf Hardware-in-the-Loop (HIL)-Systemen einfach wiederverwendet werden.

Für SIL-Tests werden in der Regel aufwendige Simulationssysteme erstellt. Diese Simulationssysteme bestehen üblicherweise einerseits aus wenigstens einem Zielmodell, auch Device-under-Test (DUT) oder System-under-Test genannt. Hinzu kommen noch Umgebungs- und Restbusmodelle, die für eine sinnvolle Simulation notwendig sind. In typischen Szenarien der Erstellung solcher Simulationssysteme sind unterschiedliche Teams für die Erstellung der Modelle verantwortlich. Diese sind insbesondere auch in unterschiedlichen Unternehmen tätig, wodurch sich besondere Anforderungen an die Geheimhaltung ergeben.

Die Modelle, die getestet werden sollen, werden also in der Regel nicht von dem Testteam erstellt, das das eigentliche Simulationssystem erstellt. Die zu testenden Modelle haben typischerweise auch viele Freiheitsgrade in der formalen Beschreibung und den Schnittstellen (Ports und Feldbusse) nach außen. Dadurch kommt es vor, dass diese Modelle sich nicht leicht in das Simulationssystem einfügen lassen, selbst wenn die Schnittstellen schriftlich und/oder grafisch festgehalten sind, z.B. in Form eines Mockup-Modells.

Ein Mockup-Modell, auch Anschauungsmodell genannt, bezeichnet im Bereich der Software-Erstellung ein reduziertes Modell einer zu erstellenden Software. Solche Anschauungsmodelle werden insbesondere in frühen Entwicklungsphasen eingesetzt, um Anforderungen an die Benutzeroberfläche bei der Zusammenarbeit von Auftraggeber und Auftragnehmer darstellen zu können. Bei einem Anschauungsmodelle handelt sich meist um ein reines Grundgerüst der Bedienelementfunktionen ohne weitere Funktionalität. In der Regel findet keine Programmierung statt, stattdessen erfolgt eine grafische Darstellung der geforderten Funktionalitäten und Kompatibilitäten.

Mockup-Modelle dienen auch Modultests, also dem Testen einzelner Teile einer Software. Mockup-Objekte dienen dabei als Platzhalter für Objekte, die für das Testen eines anderen Teils benötigt werden und zum Beispiel bei Beginn der Entwicklung noch nicht vorhanden sind. In einem späteren Entwicklungsstadium werden Mockup-Objekte z.B. benutzt, wenn die Initialisierung eines vorhandenen und funktionsfähigen Objekts zu aufwändig oder in einer Testumgebung mangels Verbindung zu produktiven Backend-Systemen nicht möglich oder nicht zulässig ist.

In P. Juhlin, A. Karaagac, J. -C. Schlake, S. Grüner and J. Rückert, "Cloud-enabled Drive-Motor-Load Simulation Platform using Asset Administration Shell and Functional Mockup Units," 2022 IEEE 27th International Conference on Emerging Technologies and Factory Automation (ETFA), Stuttgart, Germany, 2022, pp. 1-8, doi: 10.1109/ETFA52439.2022.9921678 wird beschrieben, dass die Entwicklung zusammengesetzter Anlagen oder Systeme die Integration und Überprüfung der einzelnen Anlagenmodelle auf Systemebene erfordert. Dies bedingt die Integration relevanter Anlagendaten und dynamischer Modelle der einzelnen Anlagen, die mit verschiedenen Entwurfs- und Simulationswerkzeugen von mehreren Anbietern entwickelt werden können. Die wichtigsten Herausforderungen der Integration, nämlich die fehlende Interoperabilität zwischen den entsprechenden Daten und Simulationsmodellen sowie die getrennten, unflexiblen Anwendungsimplementierungen, werden in diesem Beitrag anhand eines Antriebs-Motor-Last-Systems behandelt. Es wird eine Cloud-fähige Antriebsmotor-Last-Simulationsplattform vorgestellt, die auf der Verwendung von Asset Administration Shells (AAS) für den automatischen Datenaustausch und Functional Mockup Units (FMUs) für die interoperable Simulation basiert, zusammen mit einer ersten Anwendung der Containerisierung zur Sicherung von Komponenten. Die Lösung soll eine höhere Qualität und Effizienz des Engineerings durch simulationsbasierte Asset-Dimensionierung, Was-wäre-wenn-Simulationen und simulationsbasierte Kalibrierung und Optimierung sowie eine flexible, benutzerfreundliche und sichere Anwendungsbereitstellung bereitstellen. Eine AAS-basierte Modellintegration für die Verknüpfung verschiedener Domänenmodelle und ihrer Parameter in den Bereichen Entwurf, Konfiguration und virtuelle Inbetriebnahme, einschließlich anwendungsseitiger Last-FMUs über AAS-Simulationssubmodelle auf der Ebene des Verbundsystems, ermöglicht die Interoperabilität von Daten und dient gleichzeitig als Baustein für den digitalen Zwilling des zukünftigen Antriebs-Motor-Last-Systems. Die Lösung ermöglicht verschiedene Anwendungen in unterschiedlichen Phasen des Produktlebenszyklus, wie z.B. Kundenkontakt vor dem Verkauf (Antrieb), simulationsbasierte Kalibrierung und Konstruktionsoptimierung während der Entwicklung, fortschrittliche Systemvalidierungen und Tests bei der virtuellen Inbetriebnahme sowie kontinuierliche Kunden- und OEM-Schulungen während der Inbetriebnahme und des Betriebs.

In J. Mezger, M. Ditze, M. Keckeisen, C. Kübler, V. Fäßler and B. Relovsky, "Protecting know-how in cross-organisational functional mock-up by a service-oriented approach with trust centres," 2011 9th IEEE International Conference on Industrial Informatics, Lisbon, Portugal, 2011, pp. 628-633, doi: 10.1109/INDIN.2011.6034951 wird beschrieben, dass in der digitalen Produktentwicklung der Automobil- und Luftfahrtindustrie das traditionelle Digital Mock-up (DMU) kurz davor steht, durch das Digital Functional Mock-up (DFMU) ergänzt und ersetzt zu werden. Das DFMU erweitert die geometrische Integration von Produktmodellen, wie sie die traditionellen DMUs bieten, um funktionale Aspekte. So können sowohl die physikalischen als auch die logischen Modelleigenschaften untersucht werden. Darüber hinaus bilden DFMUs die Grundlage für eine integrierte Analyse der ganzheitlichen Verhaltensaspekte eines Produkts. Der Entwurf von DFMUs wird durch eine kosteneffiziente Co-Simulation validiert - eine Methodik zur gleichzeitigen Simulation einzelner Komponenten durch verschiedene Simulationswerkzeuge, die in kollaborativer Weise gegenseitig Informationen austauschen. Dieser Prozess kann in hohem Maße organisations-übergreifend sein und erfordert daher einen Austausch von kostensensiblen und vertraulichen Produktmodellen zwischen Zulieferern und OEMs (Besteller). In diesem Beitrag wird der Einsatz serviceorientierter Architekturen in Co-Simulationsumgebungen erörtert, um den Konfigurationsprozess zu verbessern, das geistige Eigentum der Modelleigentümer zu schützen und elektronische Signaturen für Simulationsmodelle, Daten und Ergebnisse einzuführen. Darüber hinaus wird das Konzept eines funktionalen Mock-up Trust Centers (FMTC) vorgestellt, das einen Teil dieser Dienste implementiert. Das FMTC ist ein praktisches und wirksames Instrument zur Wahrung der geistigen Eigentumsrechte von Modellanbietern während der Co-Simulation. Erreicht wird dies durch verschlüsselte Speichermöglichkeiten für Produktmodelle und eine geschützte Simulationsumgebung.

In Hatledal, Lars & Styve, Arne & Hovland, Geir & Zhang, Houxiang. (2019). A Language and Platform Independent Co-Simulation Framework Based on the Functional Mock-Up Interface. IEEE Access. PP. 1-1. 10.1109/ACCESS.2019.2933275 wird beschrieben, dass das Hauptziel des Functional Mock-up Interface (FMI)-Standards darin besteht, die gemeinsame Nutzung von Simulationsmodellen durch verschiedene Werkzeuge zu ermöglichen. Um dies zu erreichen, stützt sich FMI auf eine Kombination aus XML-Dateien und kompiliertem C-Code, die in einem Zip-Archiv verpackt sind. Dieses Archiv wird als Functional Mock-up Unit (FMU) bezeichnet. Theoretisch kann eine FMU mehrere Plattformen unterstützen, aber nicht unbedingt in der Praxis. Außerdem kann es sein, dass Softwarebibliotheken für die Interaktion mit FMUs in einer bestimmten Sprache oder Plattform nicht verfügbar sind. Ein weiteres Problem ist der Schutz des geistigen Eigentums. Während es einer FMU freisteht, nur den C-Code in seiner binären Form zur Verfügung zu stellen, können andere Ressourcen innerhalb der FMU ungeschützt sein. Die Verteilung von Modellen in binärer Form eröffnet auch die Möglichkeit, dass sie bösartigen Code enthalten. Um diese Herausforderungen zu meistern, wird in dieser Veröffentlichung ein auf FMI basierendes Open-Source-Co-Simulations-Framework vorgestellt, das dank der Verwendung etablierter Remote-Procedure-Call (RPC)-Technologien sprach- und plattformunabhängig ist. Eine oder mehrere FMUs sind in einem Serverprogramm verpackt, das ein oder mehrere sprachunabhängige RPC-Systeme über verschiedene Netzwerkprotokolle unterstützt. Zusammen ermöglichen sie den plattformübergreifenden Aufruf von FMUs aus mehreren, auch bisher nicht unterstützten, Sprachen. Die Client-Server-Architektur ermöglicht einen wirksamen Schutz des geistigen Eigentums und bietet gleichzeitig ein Mittel zum Schutz der Benutzer vor bösartigem Code.

Es ist die Aufgabe der Erfindung, ein effizientes Verfahren zum Erstellen eines Mockup-Systems für ein Simulationssystem bereitzustellen, wobei durch das Mockup-Modell so wenig Information über das Simulationssystem offenbart werden soll, wie möglich.

Diese Aufgabe wird durch den Gegenstand des Patentanspruchs 1 gelöst. Bevorzugte Weiterbildungen finden sich in den Unteransprüchen.

Erfindungsgemäß wird somit ein Verfahren zum Erstellen eines Restmodells für ein eine Mehrzahl von Teilmodellen aufweisendes Simulationssystem, mit folgenden Verfahrensschritten bereitgestellt:
Auswählen mindestens eines Teilmodells als Zielmodell, das nicht im Restmodell enthalten sein soll,
Erfassen von Ports des Simulationssystems, die mit Ports des Zielmodells verbunden werden müssen,
Erstellen von den erfassten Ports entsprechender Ports mit identischen Eigenschaften in dem Restmodell,
Erfassen von Feldbussen des Simulationssystems, die mit dem Zielmodell verbunden werden müssen, und
Erstellen von für die erfassten Feldbussen geeigneten Feldbus-Controllern in dem Restmodell.

Ein wesentlicher Aspekt der Erfindung liegt somit darin, dass aus dem Simulationssystem ein Restmodell extrahiert wird, das sich aus der Sicht des Zielmodells inhaltlich und von den Schnittstellen (Ports und Feldbusse) her gleich verhält wie das ursprüngliche Simulationssystem. Mit anderen Worten: Das Restmodell ist ein vereinfachtes Modell für das Simulationssystem ohne das Zielmodell, wobei das Restmodell nur solche Funktionen zwingend aufweist, die zum Testen des Zielmodells erforderlich sind.

Der Begriff "Schnittstelle" ist der Oberbegriff für die Begriffe "Ports" und "Feldbusse". Dabei bezeichnet der Begriff "Port" einen Datenübergabepunkt und der Begriff "Feldbus" steht für eine modellierte Kommunikationshardware. Ports stellen also eine Schnittstelle zur Datenübertragung dar. Dabei muss nicht festgelegt sein, mit welchem Mechanismus diese Daten übertragen werden. Das können z.B. ein gemeinsam genutzter Speicherbereich, ein Funktionsaufruf oder direkte Kabelverbindungen sein. Das kann im Übrigen auch eine 1:n Verbindung sein, die von Port zu Port verläuft. Feldbusse können grundsätzlich auch mit Ports abgebildet werden, und es können ihnen bestimmte Eigenschaften zugewiesen werden, die den jeweiligen Feldbus charakterisieren. Insbesondere bei automotiver Software und verteilten System haben Feldbusse eine wichtige Rolle, so dass sie vorliegend als eigene Schnittstellen behandelt werden.

Unter dem Begriff "Feldbus-Controller" wird vorliegend ganz allgemein ein Zugangspunkt verstanden, der die Funktionen von einem oder mehrere Controller für einen Feldbus abbildet. Feldbus-Controller werden also eingesetzt, um die Kommunikation zwischen verschiedenen Feldgeräten, wie Sensoren, Aktuatoren und Steuerungseinheiten zu ermöglichen und zu verwalten. Feldbusse umfassen somit Kommunikationsprotokolle, die eingesetzt werden, um den Informationsaustausch und die Steuerung der verschiedenen Komponenten zu ermöglichen. Ein Feldbus-Controller ermöglicht also die zentrale Koordination der Kommunikation, indem er den Datenaustausch zwischen den Feldgeräten organisiert und steuert. Dabei kann der Feldbus-Controller Daten empfangen, verarbeiten und an die entsprechenden Geräte senden. Dadurch werden Echtzeit-Steuerung und Überwachung von entsprechenden Prozessen möglich.

Wenn es vorliegend heißt, dass für die erfassten Feldbussen geeignete Feldbus-Controller in dem Restmodell erzeugt werden, dann bedeutet dies also, dass die erzeugten Feldbus-Controller so ausgestaltet sind, dass mit ihnen die Kommunikation zwischen mittels den erfassten Feldbussen angeschlossenen Feldgeräten im oben beschriebenen Sinne gesteuert werden kann.

Grundsätzlich ist die Erfindung für unterschiedliche Arten von Ports nutzbar. Gemäß einer bevorzugten Weiterbildung der Erfindung umfassen die Ports jedoch wenigstens einen Kommunikations-Port. Die Eigenschaften der Ports können grundsätzlich unterschiedliche Arten von Daten umfassen. Gemäß einer bevorzugten Weiterbildung der Erfindung umfassen die Eigenschaften der Ports jedoch Namen, Übertragungshäufigkeit, Datenbreite und/oder Typdaten. Darüber hinaus ist gemäß einer bevorzugten Weiterbildung der Erfindung vorgesehen, dass nicht erfasste Ports und Feldbus-Controller nicht erfasster Feldbusse nicht ins Restmodell eingefügt werden.

Die Erfindung geht davon aus, dass das Restmodell wenigstens noch ein Teilmodell aufweist, mit dem das zu entwickelnde Zielmodell kompatibel sein muss. Typischerweise weist das Restmodell jedoch eine Mehrzahl von Teilmodellen auf. In diesem Zusammenhang ist es gemäß einer bevorzugten Weiterbildung der Erfindung vorgesehen, dass das Verfahren zusätzlich den folgenden Verfahrensschritte aufweist, wenn das Restmodell eine Mehrzahl von Teilmodellen aufweist:
Vereinigen der Teilmodelle in dem Restmodell in einem einzigen Modell mit der gleichen Semantik.

Vorzugsweise gilt dabei, dass das Vereinigen der Teilmodelle in dem Restmodell in einem einzigen Modell mit der gleichen Semantik die folgenden Verfahrensschritte umfasst:
Übernehmen von Implementierungen der Teilmodelle in dem Restmodell, die jeweils dieselben Funktionen aufweisen wie die Teilmodelle in dem ursprünglichen Simulationssystem,
Erzeugen von Code für Kommunikationsverbindungen zwischen den Teilmodellen des Restmodells und Bereitstellen des erzeugten Codes in dem Restmodell und
Einrichten von Weiterleitungen von Aufrufen des Zielmodells an das Restmodell an die Implementierungen der Teilmodelle in dem Restmodell.

Wenn wenigstens ein Teilmodell periodische Aufrufe aufweist, sind gemäß einer bevorzugten Weiterbildung der Erfindung die folgenden Verfahrensschritte vorgesehen:
Bilden einer Obermenge eines Zeitrasters der Aufrufe und
Überführen der Aufrufe in Zeitraster des Restmodells.

In diesem Zusammenhang ist insbesondere der folgenden Verfahrensschritt besonders bevorzugt:
Erstellen einer vorbestimmten Reihenfolge für den Aufruf der Implementierungen der Teilmodelle in dem Restmodell.

Dabei wird die Reihenfolge vorzugsweise statisch sequenziell oder parallel oder derart gewählt, wie die Reihenfolge bei dem ursprünglichen Simulationssystem war.

Außerdem hat es sich als nützlich herausgestellt und ist insofern besonders bevorzugt, dass in einem Fall, dass die Teilmodelle jeweils eine eigene Variablenbeschreibung aufweisen, die Variablenbeschreibungen der Teilmodelle in einer gemeinsamen Variablenbeschreibung vereinigt werden, so dass Messungen und Stimulation der Variablen im Restmodell auf der Grundlage dieser gemeinsamen Variablenbeschreibung ermöglicht werden. Dabei werden Klarnamen vorzugsweise verschleiert.

Darüber hinaus ist gemäß einer bevorzugten Weiterbildung der Erfindung der folgende Verfahrensschritt als letzter Verfahrensschritt vorgesehen:
Verbinden des Zielmodells mit dem Restmodell, so dass das daraus entstehende Simulationssystem sich wie das ursprüngliche Simulationssystem verhält.

Nachfolgend wir die Erfindung anhand eines bevorzugten Ausführungsbeispiels unter Bezugnahme auf die Zeichnungen weiter im Detail erläutert.

In den Zeichnungen zeigen
Fig. 1 schematisch das Erstellen eines Restmodells für ein eine Mehrzahl von Teilmodellen aufweisendes Simulationssystem gemäß einem bevorzugten Ausführungsbeispiel der Erfindung,
Fig. 2 ein Beispiel für ein Simulationssystem,
Fig. 3 eine Reduzierung des Simulationssystems aus Fig. 2 zu einem Mockup-System gemäß einem bevorzugten Ausführungsbeispiel der Erfindung,
Fig. 4 eine Reduzierung des Simulationssystems aus Fig. 2 zu einem noch stärker reduzierten Mockup-System gemäß einem bevorzugten Ausführungsbeispiel der Erfindung und
Fig. 5 ein Ablaufdiagramm für ein Verfahren gemäß einem bevorzugten Ausführungsbeispiel der Erfindung.

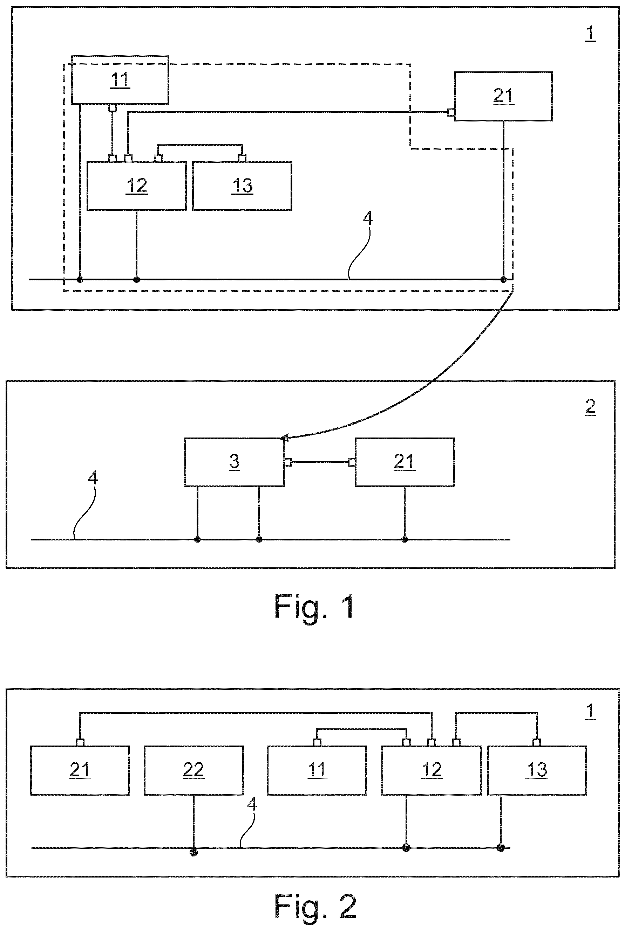

In Fig. 1 ist schematisch und generell das Erstellen eines Restmodells 3 für ein eine Mehrzahl von Teilmodellen 11, 12, 13, 21 aufweisendes Simulationssystem 1 gemäß einem bevorzugten Ausführungsbeispiel der Erfindung illustriert. Die Teilmodelle 11, 12, 13, 21 sind über Buskommunikationsverbindungen 4 miteinander verbunden. Die Grundidee liegt nun darin, ein Teilmodell 21 als Zielmodell 21 auszuwählen und alle anderen Teilmodelle 11, 12, 13, die mit dem Zielmodell 21 in Kommunikation stehen, in das Restmodell 3 zu überführen, was in Fig. 1 mit dem geschwungenen Pfeil dargestellt ist.

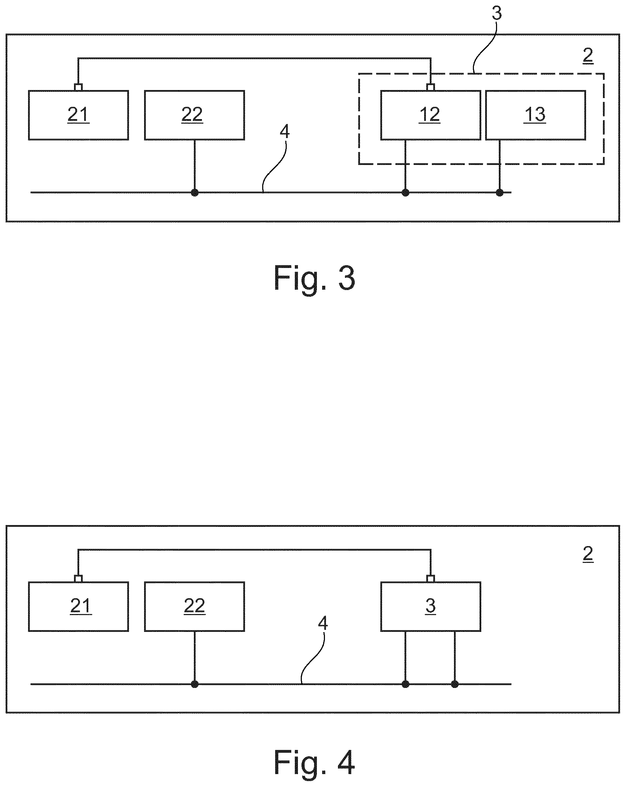

So ist es z.B. auch möglich, dass ein Simulationssystem 1 so ausgestaltet ist, wie in Fig. 2 dargestellt, und dann in ein Mockup-System 2 überführt wird, wie in Fig. 3 bzw. Fig. 4 dargestellt. Das Simulationssystem 1 weist hier fünf Teilmodelle 11, 12, 13, 21, 22 auf, von denen zwei als Zielmodelle 21, 22 ausgewählt werden, die nicht im Restmodell 3 enthalten sein sollen. Da nun das Teilmodell 11 nur mit dem Teilmodell 12 in Verbindung steht und nicht mit den beiden Zielmodellen 21, 22 kommuniziert, kann bei der Erstellung des Mockup-Systems 2 das Teilmodell 11 weggelassen werden, ohne dass damit eine Prüfung der Zielmodelle 21, 22 mittels des Mockup-Systems 2 erschwert oder gar unmöglich gemacht werden würde. Dies ist in Fig. 3 dargestellt. Das Restmodell 3 ist dort praktisch die auf die Teilmodelle 12, 13 reduzierte Modellgruppe.

In Fig. 4 ist dargestellt, dass darüber hinaus eine weitere Reduktion in dem Mockup-Modell 2 erfolgen kann, indem die Teilmodelle 12, 13 in ein Restmodell 3 überführt werden, bei dem bestimmte Details der Teilmodelle 12, 13, die für die Interoperabilität mit den Zielmodellen 21, 22 nicht maßgeblich sind, nach außen hin verschleiert werden.

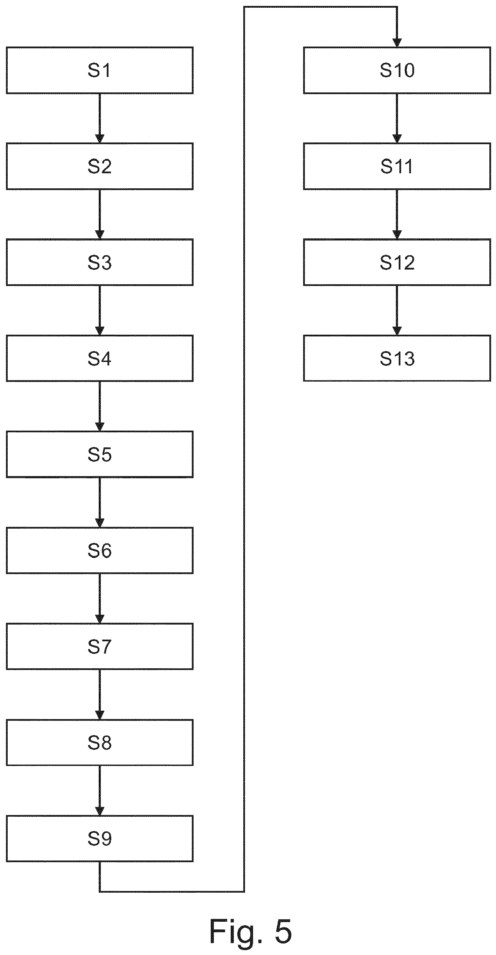

Nach dieser generellen Beschreibung der Grundidee der vorliegenden Erfindung wird nachfolgend ein konkreter Verfahrensablauf gemäß einem bevorzugten Ausführungsbeispiel der Erfindung anhand von Fig. 5 erläutert. Dabei handelt es sich um ein Verfahren zum Erstellen eines Restmodells 3 für ein eine Mehrzahl von Teilmodellen 11, 12, 13, 21, 22 aufweisendes Simulationssystem 1, wie z.B. in Fig. 2 dargestellt, mit folgenden Verfahrensschritten:
S1) Auswählen mindestens eines Teilmodells 11, 12, 13, 21, 22 als Zielmodell 21, 22, das nicht im Restmodell 3 enthalten sein soll,
S2) Erfassen von Ports des Simulationssystems 1, die mit Ports des Zielmodells 21, 22 verbunden werden müssen,
S3) Erstellen von den erfassten Ports entsprechender Ports mit identischen Eigenschaften in dem Restmodell 3,
S4) Erfassen von Feldbussen des Simulationssystems 1, die mit dem Zielmodell 21, 22 verbunden werden müssen, und
S5) Erstellen von für die erfassten Feldbussen geeigneten Feldbus-Controller in dem Restmodell 3.

Dabei umfassen die Ports Kommunikations-Ports zur Kommunikation der Teilmodelle 11, 12, 13, 21, 22 untereinander und als Eigenschaften der Ports werden deren Namen, Übertragungshäufigkeit, Datenbreite und Typdaten berücksichtigt. Dabei ist es aber auch so, dass nicht erfasste Ports und Feldbus-Controller nicht erfasster Feldbusse nicht ins Restmodell 3 eingefügt werden.

Bei dem hier beschriebenen bevorzugten Ausführungsbeispiel der Erfindung weist das Restmodell 3 eine Mehrzahl von Teilmodellen 12, 13 auf, nämlich zwei. Bei dieser Situation von mehreren Teilmodellen 12, 13 für das Restmodell 3 können die Teilmodelle 12, 13, wie in Fig. 3 dargestellt, in dem Restmodell 3 in einem einzigen Modell mit der gleichen Semantik vereinigt werden, wobei das Vereinigen der Teilmodelle 12, 13 in dem Restmodell 3 in einem einzigen Modell mit der gleichen Semantik die folgenden Verfahrensschritte umfasst:
S6) Übernehmen von Implementierungen der Teilmodelle 12, 13 in dem Restmodell 3, die jeweils dieselben Funktionen aufweisen wie die Teilmodelle 12, 13 in dem ursprünglichen Simulationssystem 1,
S7) Erzeugen von Code für Kommunikationsverbindungen zwischen den Teilmodellen 12, 13 des Restmodells 3 und Bereitstellen des erzeugten Codes in dem Restmodell 3 und
S8) Einrichten von Weiterleitungen von Aufrufen des Zielmodells 21, 22 an das Restmodell 3 an die Implementierungen der Teilmodelle 12, 13 in dem Restmodell 3.

Vorliegend weisen die Teilmodelle 12, 13 periodische Aufrufe auf, so dass sich die folgenden Verfahrensschritte anschließen:
S9) Bilden einer Obermenge eines Zeitrasters der Aufrufe,
S10) Überführen der Aufrufe in Zeitraster des Restmodells 3 und
S11) Erstellen einer vorbestimmten Reihenfolge für den Aufruf der Implementierungen der Teilmodelle 11, 12, 13 in dem Restmodell 3.

Dabei kann die Reihenfolge statisch sequenziell oder parallel oder derart gewählt werden, wie die Reihenfolge bei dem ursprünglichen Simulationssystem 1 war.

Bei den hier beschriebenen bevorzugten Ausführungsbeispiele der Erfindung gilt weiterhin, dass die Teilmodelle 12, 13 jeweils eine eigene Variablenbeschreibung aufweisen. Insofern ist Verfahrensschritt S12) vorgesehen, in dem die Variablenbeschreibungen der Teilmodelle 12, 13 in einer gemeinsamen Variablenbeschreibung vereinigt werden, so dass Messungen und Stimulation der Variablen im Restmodell 3 auf der Grundlage dieser gemeinsamen Variablenbeschreibung ermöglicht werden. Dabei werden die Klarnamen der Variablen mittels eines Computerprogramms verschleiert.

Das Verfahren endet mit dem abschließenden Verfahrensschritt S13), in dem, wie in Fig. 4 dargestellt, die Zielmodelle 21, 22 mit dem Restmodell 3 verbunden werden, so dass das daraus entstehende Mockup-System 2 sich wie das ursprüngliche Simulationssystem 1 verhält und für entsprechende Tests genutzt werden kann.

Wesentlich bei dem vorliegend beschriebenen bevorzugten Ausführungsbeispiele der Erfindung ist also, dass nur solche Teilmodelle 12, 13 im Restmodell 3 des Mockup-System 2 enthalten sind, die eine unmittelbare Verbindung mit den Zielmodellen 21, 22 besitzen. Dabei sind auch nur solche Verbindungspunkte (Ports, Busse) in dem Restmodell 3 enthalten, die eine unmittelbare Verbindung mit den Zielmodellen 21, 22 aufweisen. Beim Überführen der Teilmodell 12, 13 in ein einziges Modell stellt ein Verbindungsskript sicher, dass die Verbindungen weiterhin korrekt gewählt sind. Darüber hinaus werden für Verbindungspunkte und Teilmodelle keine Klarnamen verwendet. Ein Verbindungsskript stellt auch hier sicher, dass die Verbindungen weiterhin korrekt gewählt sind. Dabei werden die gesamten Kommunikationsdaten für die ersten Zeitschritte aufgenommen und automatisiert in das Mockup-System 2 als Verhalten überführt.

Durch dieses Verfahren kann ein Hersteller, also der Besteller der Zielsysteme 21, 22, einen Abnahmetest gegenüber einem Zulieferer der Zielsysteme 21, 22 mit dem Mockup-System 2 definieren, der es sicherstellt, dass sich die zugelieferten Zielmodelle 21, 22 ohne manuelle Zuarbeiten in das Simulationssystem 1 einfügen lassen. Das ist insbesondere in Cloud-Szenarien wichtig: Dem Zulieferer wird vor Ort außerhalb der Cloud das Mockup-System 2 zur Verfügung gestellt, um seine Zielmodelle 21, 22 lauffähig zu machen. Wenn der Zulieferer mittels des Mockup-Systems 2 sicher ist, dass das Modell in der Test-Cloud erfolgreich eingebunden werden kann, spart das nicht nur Zeit, sondern schafft auch Handlungssicherheit auf beiden Seiten. Die erfolgreiche Inbetriebnahme mit dem Mockup-System 2 kann auch als Kriterium festgelegt werden, wann ein Zielmodell 21, 22 vom Besteller akzeptiert wird. Mit einem entsprechenden "Siegel" können die Zielmodelle 21, 22 dann an die Cloud des Bestellers übertragen und die Zielmodelle 21, 22 in entsprechende Tests automatisch übernommen werden, ohne dass der Besteller Details über seinen Test preisgibt.

Wenn die Klarnamen oder die Simulationstopologie verschleiert werden, werden die Klarnamen vor der Erstellung des Mockup-Systems 2 vorliegend mit einem zufällig generierten Bezeichner ersetzt. Die Verbindungsinformationen bleiben dabei bestehen und werden gesichert. Dadurch kann die gleiche Verbindung beim Mockup-System 2 reproduziert werden, ohne dass die Topologie des Simulationssystems 1 bekannt ist.

### Bezugszeichenliste

- 1: Simulationssystem
- 2: Mockup-System
- 3: Restmodell
- 4: Buskommunikationsverbindungen
- 11: Teilmodell
- 12: Teilmodell
- 13: Teilmodell
- 21: Zielmodell
- 22: Zielmodell

## Patentansprüche

1. Verfahren zum Erstellen eines Restmodells (3) für ein eine Mehrzahl von Teilmodellen (11, 12, 13, 21, 22) aufweisendes Simulationssystem (1), mit folgenden Verfahrensschritten:
Auswählen mindestens eines Teilmodells (11, 12, 13, 21, 22) als Zielmodell (21, 22), das nicht im Restmodell (3) enthalten sein soll,
Erfassen von Ports des Simulationssystems (1), die mit Ports des Zielmodells (21, 22) verbunden werden müssen,
Erstellen von den erfassten Ports entsprechender Ports mit identischen Eigenschaften in dem Restmodell (3),
Erfassen von Feldbussen des Simulationssystems (1), die mit dem Zielmodell (21, 22) verbunden werden müssen, und
Erstellen von für die erfassten Feldbussen geeigneten Feldbus-Controllern in dem Restmodell (3).

2. Verfahren nach Anspruch 1, wobei die Ports wenigstens einen Kommunikations-Port umfassen.

3. Verfahren nach Anspruch 1 oder 2, wobei die Eigenschaften Namen, Übertragungshäufigkeit, Datenbreite und/oder Typdaten umfassen.

4. Verfahren nach einem der vorhergehenden Ansprüche, wobei nicht erfasste Ports und Feldbus-Controller nicht erfasster Feldbusse nicht ins Restmodell (3) eingefügt werden.

5. Verfahren nach einem der vorhergehenden Ansprüche, mit folgendem Verfahrensschritt, wenn das Restmodell (3) eine Mehrzahl von Teilmodellen (11, 12, 13) aufweist:
Vereinigen der Teilmodelle (11, 12, 13) in dem Restmodell (3) in einem einzigen Modell mit der gleichen Semantik.

6. Verfahren nach Anspruch 5, wobei das Vereinigen der Teilmodelle (11, 12, 13) in dem Restmodell (3) in einem einzigen Modell mit der gleichen Semantik die folgenden Verfahrensschritte umfasst:
Übernehmen von Implementierungen der Teilmodelle (11, 12, 13) in dem Restmodell (3), die jeweils dieselben Funktionen aufweisen wie die Teilmodelle (11, 12, 13) in dem ursprünglichen Simulationssystem (1),
Erzeugen von Code für Kommunikationsverbindungen zwischen den Teilmodellen (11, 12, 13) des Restmodells (3) und Bereitstellen des erzeugten Codes in dem Restmodell (3),
Einrichten von Weiterleitungen von Aufrufen des Zielmodells (21, 22) an das Restmodell (3) an die Implementierungen der Teilmodelle (11, 12, 13) in dem Restmodell (3).

7. Verfahren nach Anspruch 6, mit folgendem Verfahrensschritt, wenn wenigstens ein Teilmodell (11, 12, 13) periodische Aufrufe aufweist:
Bilden einer Obermenge eines Zeitrasters der Aufrufe und
Überführen der Aufrufe in Zeitraster des Restmodells (3).

8. Verfahren nach Anspruch 6 oder 7, mit folgendem Verfahrensschritt:
Erstellen einer vorbestimmten Reihenfolge für den Aufruf der Implementierungen der Teilmodelle (11, 12, 13) in dem Restmodell (3).

9. Verfahren nach Anspruch 8, wobei die Reihenfolge statisch sequenziell oder parallel oder derart gewählt wird, wie die Reihenfolge bei dem ursprünglichen Simulationssystem (1) war.

10. Verfahren nach einem der vorhergehenden Ansprüche, wobei die Teilmodelle (11, 12, 13) jeweils eine eigene Variablenbeschreibung aufweisen und die Variablenbeschreibungen der Teilmodelle (11, 12, 13) in einer gemeinsamen Variablenbeschreibung vereinigt werden, so dass Messungen und Stimulation der Variablen im Restmodell (3) auf der Grundlage dieser gemeinsamen Variablenbeschreibung ermöglicht werden.

11. Verfahren nach einem der vorhergehenden Ansprüche, mit folgendem Verfahrensschritt:
Verbinden des Zielmodells (21, 22) mit dem Restmodell (3), so dass das daraus entstehende Mockup-System (2) sich wie das ursprüngliche Simulationssystem (1) verhält.
